# EUROPÄISCHE PATENTSCHRIFT

(11) **EP 4 237 705 B1**
(45) Veröffentlichungstag und Bekanntmachung des Hinweises auf die Patenterteilung: **04.12.2024**
(21) Anmeldenummer: 21799266.8
(22) Anmeldetag: 26.10.2021
(51) Int. Cl.: F16H 57/025, F16H 57/00, F16H 57/023, F16D 1/00

(54) **ANORDNUNG MIT EINEM GETRIEBE UND EINER ARBEITSMASCHINE, VERFAHREN ZUR SIMULATION**
ARRANGEMENT WITH A TRANSMISSION AND A WORKING MACHINE, METHOD FOR SIMULATION
AGENCEMENT DOTÉ D'UN ENGRENAGE ET D'UNE MACHINE DE TRAVAIL, PROCÉDÉ DE SIMULATION

(30) Priorität: 29.10.2020 EP 20204725
(43) Veröffentlichungstag der Anmeldung: 06.09.2023
(73) Patentinhaber: Flender GmbH, 46395 Bocholt (DE)
(72) Erfinder: DÜVEL, Volker, 46397 Bocholt (DE); SCHROER, Dirk, 46414 Rhede (DE); BECKA, Simon, 46487 Wesel (DE)
(74) Vertreter: Michalski Hüttermann & Partner Patentanwälte mbB
(86) Internationale Anmeldenummer: PCT/EP2021/079606
(87) Internationale Veröffentlichungsnummer: WO 2022/090187

(56) Entgegenhaltungen:
- EP-A1- 3 702 647
- CN-U- 203 594 733
- US-A1- 2007 290 509
- US-A1- 2013 130 862
- US-A1- 2018 251 353

## Beschreibung

Die Erfindung betrifft eine Anordnung umfassend ein antriebsseitiges Getriebe mit einer Abtriebswelle des Getriebes, die sich entlang einer Achse erstreckt, und umfassend eine Arbeitsmaschine mit einer mit der Abtriebswelle drehsteif verbundenen Antriebswelle.

Daneben umfasst die Erfindung auch ein computerimplementiertes Verfahren zur Simulation einer Anordnung und ein entsprechendes Computerprogrammprodukt zur Durchführung dieses Verfahrens mittels mindestens eines Computers.

Derartige Anordnungen sind häufig raumgreifend und neigen infolge höherer Belastungen bei gleichzeitig geforderter Kompaktheit schnell zur Überlastung.

Eine Anwendungsmöglichkeit für eine gattungsgemäße Anordnung ist in der EP 2 989 351 A1 gezeigt.

Aus US 2018/0251353 A1 ist eine als Hohlwelle ausgestaltete Antriebswelle eines Motors bekannt, die radial innen über eine Innenverzahnung mit einer radial außen vorgesehenen Kurzverzahnung einer Abtriebswelle eines über eine Drehmomentstütze abgestützten Getriebes drehfest gekoppelt ist.

Aus CN 203 594 733 U ist ein Getriebe für einen Extruder bekannt, bei dem eine Antriebsleistung über Stirnradstufen an ein über eine Drehmomentstütze abgestütztes Planetengetriebe übertragen wird, dessen zweiteilige Ausgangswelle an unterschiedlichen Seiten des Getriebes herausragt, um die jeweiligen Extruderschnecken anzutreiben. Die mit einem Planetenträger des Planetengetriebes verbundene zweiteilige Ausgangswelle weist zwei über eine Kurzverzahnung drehfest miteinander verbundene Hohlwellen auf, mit denen die zugehörige Extruderschnecke über eine Verzahnung oder eine Flanschverschraubung befestigt werden kann.

Aus EP 3 702 647 A1 ist ein Getriebe für eine Windkraftanlage bekannt, bei dem eine Antriebsleistung über eine Stirnradstufe von einem über eine Drehmomentstütze abgestütztes Planetengetriebe an einen Generator ausgeleitet wird, wobei die Stirnradstufe über eine Kurzverzahnung mit einer als Hohlwelle ausgestalteten Sonnenwelle drehfest gekoppelt ist. Die Stirnradstufe weist eine aus dem Getriebegehäuse herausragende Abtriebswelle auf, die als Vollwelle ausgestaltet ist.

Aus US 2007/2950509 A1 ist ein Getriebe für eine Windkraftanlage bekannt, bei dem eine Antriebsleistung über einen Planetenträger eines über eine Drehmomentstütze abgestützten Planetengetriebes eingeleitet und über eine Sonnenwelle an einen Generator ausgeleitet wird, wobei die Sonnenwelle als Vollwelle ausgestaltet ist.

Ausgehend von den zuvor beschriebenen Problemen liegt der Erfindung die Aufgabe zugrunde, eine zuverlässige Anordnung eingangs definierter Art zu schaffen, die bei moderatem Raumbedarf den hohen anfallenden Lasten standhält.

Zur Lösung der Aufgabe schlägt die Erfindung eine Anordnung der eingangs definierten Art vor, bei der das Getriebe an der Arbeitsmaschine mittels der Verbindung der Abtriebswelle mit der Antriebswelle und mittels einer Drehmomentstütze zu mindestens 90% der im Betrieb entstehenden Kräfte abgestützt ist, wobei die Verbindung der Abtriebswelle mit der Antriebswelle zur Abstützung von Querkräften biegesteif ausgebildet ist, wobei das axiale Ende der Antriebswelle als Hohlwelle ausgeführt ist, wobei das axiale Ende der Abtriebswelle einen Stumpf aufweist, der zumindest teilweise in der Hohlwelle der Antriebswelle angeordnet ist.

Die Antriebswelle weist in dem Bereich der Ausbildung als Hohlwelle eine Ausformung auf, wobei an dem als Stumpf ausgebildeten axialen Ende der Abtriebswelle ein Halteelement mittels Befestigungsmitteln befestigt ist, derart, dass die Ausformung in dem Bereich zwischen dem Halteelement und einer axialen Anlagefläche der sonstigen Abtriebswelle eingeklemmt ist. Bevorzugt besteht das Halteelement aus Metall. Auf diese Weise kann der Flansch an der Abtriebswelle mittels des Halteelements angebracht werden und anschließend kann der Flansch an der Antriebswelle befestigt werden. Besonders zweckmäßig für die Einfachheit der Montage sowie für die Festigkeit und die Laufruhe kann bei der Anordnung der Erfindung das Halteelement, das besonders vorteilhaft ringförmig, also als Haltering ausgebildet sein kann, einteilig ausgeführt werden. Besonders bevorzugt ermöglicht die erfindungsgemäße Anordnung eine freie axiale Zugänglichkeit zu der Montageposition des Halteelements, insbesondere ohne, dass eine sich axial erstreckende Fortsetzung einer Welle eine teilbare - mindestens 2-teilige Ausführung des Halteelements erfordert.

Die erfindungsgemäße Anordnung umfasst als Getriebe bevorzugt ein Planetengetriebe und ist bevorzugt Bestandteil einer Rollenpresse oder einer Mühle, z.B. einer Zuckermühle, bevorzugt mit Individualantrieb oder diverser anderer Anwendungen im Industriebereich.

Die erfindungsgemäße Anordnung kann hinsichtlich des Getriebes als "wellenreitend gelagert" bezeichnet werden. Dies bedeutet, dass die Abtriebswelle des Getriebes oder Planetengetriebes auf der Antriebswelle der Arbeitsmaschine befestigt ist, derart, dass die Abtriebswelle und das Getriebes dort gegen Querkräfte abgestützt sind. Das Drehmoment am Getriebe bzw. Getriebegehäuse wird mittels einer Drehmomentstütze abgeleitet, z.B. indirekt oder direkt in ein Fundament eingeleitet. Die Ableitung des Drehmoments kann hierbei auch mittels benachbarter Maschinenelemente erfolgen, z.B. über die Arbeitsmaschine, an der die Drehmomentstütze angebracht ist. Die Drehmomentstütze ist hierbei an dem Getriebe derart angebracht, dass das Getriebe an einer axialen Drehung (bzgl. der Abtriebswelle) gehindert ist. Andere Freiheitsgrade der Bewegung werden von der Drehmomentstütze bevorzugt nicht eingeschränkt.

Die Antriebswelle der Arbeitsmaschine ist insbesondere starr mit der Abtriebswelle des Getriebes gekoppelt, so dass vorzugsweise ein radialer Versatz und/oder Verkippbarkeit zwischen der Antriebswelle der Arbeitsmaschine und der Abtriebswelle des Getriebes eliminiert ist. Insbesondere sind die Drehachsen der Antriebswelle der Arbeitsmaschine und der Abtriebswelle des Getriebes koaxial zueinander ausgerichtet, so dass die Drehachsen der Antriebswelle der Arbeitsmaschine und der Abtriebswelle des Getriebes zusammenfallen können. Vorzugsweise ist im montierten Zustand auch eine axiale Relativbewegung der Antriebswelle der Arbeitsmaschine relativ zu der Abtriebswelle des Getriebes blockiert. Die Antriebswelle der Arbeitsmaschine und die Abtriebswelle des Getriebes können zueinander zentriert sein. In der Anordnung auftretende Drehmomente können dadurch nahezu vollständig, insbesondere zu mindestens 90%, über die Drehmomentstütze abgestützt sein. Ein von der Arbeitsmaschine über die Antriebswelle in das Getriebe eingeleitetes abzustützendes Drehmoment wird dadurch nicht an der Verbindungsstelle der Antriebswelle der Arbeitsmaschine mit der Abtriebswelle des Getriebes abgestützt, sondern über die Abtriebswelle des Getriebes abgeleitet und zu der Antriebswelle der Arbeitsmaschine beabstandet erst über die Drehmomentstütze abgestützt. Das von Arbeitsmaschine eingeleitete abzustützende Drehmoment kann dadurch über die einzelnen Verzahnungen des Getriebes weitergeleitet werden, bis es über die Drehmomentstütze abgestützt werden kann. Das Getriebe ist insbesondere als mindestens einstufiges, vorzugsweise mehrstufiges, Planetengetriebe ausgestaltet, von dem eine verzahnte Getriebekomponente, beispielsweise ein feststehendes Hohlrad, mit einem Getriebegehäuse fest verbunden ist, mit dem wiederum die Drehmomentstütze verbunden sein kann. Das von Arbeitsmaschine eingeleitete abzustützende Drehmoment wird dadurch über die einzelnen Verzahnungen des Getriebes bis an das Getriebegehäuse und die Drehmomentstütze geleitet und abgestützt, so dass bei einer guten Stabilität ein geringer Bauraumbedarf erreicht ist.

Die Antriebswelle der Arbeitsmaschine ist insbesondere im Wesentlichen nur in einem Axialbereich, in dem die Antriebswelle die Abtriebswelle des Getriebes radial außen umgreift, als Hohlwelle ausgestaltet und im Übrigen als Vollwelle ausgestaltet. Der die Hohlwelle ausbildende Bereich der Antriebswelle ist beispielsweise als zylindrische Vertiefung ausgestaltete, die an einer axialen Stirnseite, beispielsweise durch Drehen, koaxial zur Drehachse der Antriebswelle eingebracht ist. Vorzugsweise ist die Abtriebswelle des Getriebes als Vollwelle ausgestaltete. Eine in axialer Richtung durchgehende zylindrische koaxialer zur Drehachse verlaufender Öffnung kann in der Abtriebswelle vermieden werden, so dass die Abtriebswelle auch bei einem im Vergleich zur Antriebswelle der Arbeitsmaschine kleineren Nenndurchmesser die auftretenden Lasten ohne signifikante Durchbiegungen übertragen kann.

Die Abtriebswelle stellt insbesondere die letzte in Drehmomentrichtung noch dem Getriebe zuzurechnende Welle dar, die insbesondere aus einem Getriebegehäuse des Getriebes herausragt oder mit der in das Getriebegehäuse des Getriebes hineinragende Antriebswelle verbunden ist. Die Abtriebswelle kann einen Leistungsausgang des Getriebes darstellen. Die Antriebswelle stellt insbesondere die erste in Drehmomentrichtung noch der Arbeitsmaschine zuzurechnende Welle dar, die insbesondere aus einem Gehäuse der Arbeitsmaschine herausragt oder mit der in das Gehäuse der Arbeitsmaschine hineinragende Abtriebswelle verbunden ist. Die Abtriebswelle kann einen Leistungseingang der Arbeitsmaschine darstellen.

Durch die biegesteife Verbindung der Antriebswelle der Arbeitsmaschine mit der Abtriebswelle des Getriebes kann eine Durchbiegung quer zur Drehachse vermieden werden. Stattdessen können insbesondere die auftretenden Querkräfte über das Getriebe an die Drehmomentstütze abgetragen und räumlich versetzt zur Verbindungstelle der Antriebswelle der Arbeitsmaschine mit der Abtriebswelle des Getriebes abgestützt werden. Dies ermöglicht es eine weitere Abstützung im Bereich der Verbindungstelle der Antriebswelle der Arbeitsmaschine mit der Abtriebswelle des Getriebes einzusparen.

Insbesondere ist die Antriebswelle an der Abtriebswelle über eine Radialabstützung zur Abtragung von Querkräften abgestützt. Die Radialabstützung ist beispielsweise durch eine Stufe oder einen Absatz ausgebildet, an der die Antriebswelle an der Abtriebswelle vorzugsweise flächig anliegen kann. Die Radialabstützung ist insbesondere Teil einer Zentrierung der Antriebswelle an der Abtriebswelle. Für die biegesteife Verbindung kann daher die quer zur Drehachse der Antriebswelle der Arbeitsmaschine und/oder der Abtriebswelle des Getriebes, also insbesondere im Wesentlichen in radialer Richtung, wirkende Radialabstützung zwischen der Antriebswelle der Arbeitsmaschine und/oder der Abtriebswelle des Getriebes vorgesehen sein, über die in radialer Richtung auftretende Querkräfte abgestützt und über das Getriebe an die Drehabstützung abgeleitet werden können.

Vorzugsweise ist die Antriebswelle an der Abtriebswelle über eine Axialabstützung zur Abtragung von Längskräften abgestützt. Die Axialabstützung ist beispielsweise durch eine Stufe oder einen Absatz ausgebildet, an der die Antriebswelle an der Abtriebswelle vorzugsweise flächig anliegen kann. Die Axialabstützung ist insbesondere Teil einer Zentrierung der Antriebswelle an der Abtriebswelle. Für die biegesteife Verbindung kann daher die längs zur Drehachse der Antriebswelle der Arbeitsmaschine und/oder der Abtriebswelle des Getriebes, also insbesondere im Wesentlichen in axialer Richtung, wirkende Axialabstützung zwischen der Antriebswelle der Arbeitsmaschine und/oder der Abtriebswelle des Getriebes vorgesehen sein, über die in axialer Richtung auftretende Längskräfte abgestützt und über das Getriebe an die Drehabstützung abgeleitet werden können.

Bevorzugt ist die Anordnung derart ausgebildet, dass das Getriebe an der Arbeitsmaschine mittels der Verbindung der Abtriebswelle mit der Antriebswelle und mittels der Drehmomentstütze vollständig gegen die im Betrieb entstehenden Kräfte abgestützt ist.

Eine Eigenschaft dieser Anordnung ist, dass die die Arbeitsmaschinenwelle und die Getriebewelle verbindende Element neben dem Antriebs-Drehmoment auch die Gewichtslasten des Getriebes sowie weiterer Komponenten (Motor, Kupplung, etc.) übertragen muss. Hierdurch entstehen an der Verbindung hohe Biegewechsellasten.

Gemäß der Erfindung ist es möglich, die für die Dimensionierung kritische Kurzverzahnung auf dem maximal möglichen Durchmesser der Abtriebswelle bzw. des Stumpfs vorzusehen. Hierbei ist es besonders zweckmäßig, wenn der Außendurchmesser der Abtriebswellenkurzverzahnung zwischen 85 - 100% des Außendurchmesser des Bereichs der Abtriebswelle aufweist, der an den Stumpf angrenzt. Im Sinne der Erfindung bezeichnet der Begriff "Stumpf" nur einen endseitigen Wellenabschnitt, der insbesondere nicht - gegenüber der übrigen Welle - einen anderen Durchmesser aufweisen muss oder in sonstiger Weise zwingend anders ausgebildet ist. Da über diese Verbindung nicht nur das Antriebs-Drehmoment sondern auch Querkräfte übertragen werden.

Eine vorteilhafte Weiterbildung der Erfindung sieht vor, dass die Antriebswelle modular aufgebaut ist, derart, dass das axiale Ende der Antriebswelle als ein erster Axialabschnitt als ein Flansch ausgebildet ist, der axial an einem zweiten Axialabschnitt der Antriebswelle angebracht ist, wobei der Flansch den endseitigen axialen Wellenabschnitt bildet, der als Hohlwelle ausgebildet ist. Insbesondere ermöglicht dieser modulare Aufbau den Einsatz der erfindungsgemäßen Anordnung mit angrenzenden Standardkomponenten. Standardmäßig kann zur Verbindung von Getriebe- und Arbeitsmaschinenwelle ein Flansch eingesetzt werden. Der Flansch wird bevorzugt mit der Antriebswelle bzw. Arbeitsmaschinenwelle verschraubt.

Besonders kostengünstig und zweckmäßig kann der Flansch als Gussbauteil, insbesondere aus Metall, ausgebildet sein. Bei einer herkömmlichen Anordnung der eingangs definierter Art ist es unter den entsprechend hohen Belastungen nur möglich, den Flansch aus einem höherfesten Material herzustellen. Die Erfindung eröffnet auch den Weg einer Ausführung als Gussbauteil. Ein geschmiedetes Teil ist deutlich teurer als eine vergleichbare Gussvariante.

Damit die erfindungsgemäße Anordnung möglichst gut radial ausgerichtet ist, kann an einem axialen Ende der Antriebswelle, mindestens eine erste radiale Antriebswellenzentrierung vorgesehen sein, wobei an einem axialen Ende der Abtriebswelle, an dem die Antriebswelle angeschlossen wird, mindestens eine radiale Abtriebswellenzentrierung vorgesehen ist, wobei die beiden Zentrierungen radial zentrierend miteinander in Kontakt stehen.

Eine besonders vorteilhafte Möglichkeit diese Biegesteifigkeit herzustellen besteht darin, dass an dem axialen Ende der Antriebswelle, eine zu der ersten radialen Antriebswellenzentrierung axial beabstandete zweite radiale Antriebswellenzentrierung vorgesehen ist, wobei an dem axialen Ende der Abtriebswelle, eine zu der ersten radialen Abtriebswellenzentrierung axial beabstandete zweite radiale Abtriebswellenzentrierung vorgesehen ist, wobei die Abtriebswellenzentrierungen und Antriebswellenzentrierungen paarweise zueinander zu zwei axial beabstandeten Zentrierungspaaren zugeordnet sind und jeweils radial zentrierend miteinander in Kontakt stehen.

Getriebeseitig wird der Flansch bei der Montage bevorzugt in die Abtriebswelle gesteckt, welche besonders bevozugt als Hohlwelle mit der innenliegenden Kurzverzahnung sowie zwei Zentriersitzen ausgeführt ist. Die Biegelasten werden so über die Zentriersitze, die Drehmomente über die Kurzverzahnung übertragen. Die axiale Verschiebung der Komponenten zueinander wird durch das Haltelement, bevorzugt ausgebildet als Haltering, verhindert. Dieser kann in Umfangsrichtung ungeteilt ausgeführt werden.

Dimensionierendes Kriterium für den Flansch ist der maximal mögliche Innendurchmesser an der Getriebeabtriebswelle. Dieser ist über ein Mindestdickenverhältnis an den Außendurchmesser der Welle gekoppelt. Mit steigender Drehmomentdichte wird der Außendurchmesser der Getriebeabtriebswelle immer kleiner, wodurch auch der mögliche Innendurchmesser kleiner wird. Dies führt ebenfalls zu einem kleineren Zapfen an dem Flansch, wodurch die auftretenden Biegewechsellasten zum dimensionierenden Kriterium werden. Hier entfaltet die erfindungsgemäße Lösung ihre Stärken.

Das bevorzugte Einsatzgebiet der Erfindung liegt im Bereich von Getrieben, wie sie an Mühlen, z.B. Zuckermühlen vorgesehen sind. Diese Getriebe sind bevorzugt als Planetengetriebe ausgebildet.

Vorteile und Ausgestaltungen der Erfindung, die einzeln oder in Kombination miteinander einsetzbar sind, sind Gegenstand der Unteransprüche.

Eine nicht beanspruchte Ausführungsform bezieht sich auch auf ein computerimplementiertes Verfahren zur Simulation eine Anordnung nach mindestens einer durch die Ansprüche definierte Merkmalskombination, bei dem insbesondere die einzelnen Bestandteile der Anordnung in einer Simulationsumgebung als computersimulierte Teile virtuell abgebildet sind und deren physikalischen Wechselwirkungen in der Simulationsumgebung vollständig oder teilweise analysiert werden. Dementsprechend umfasst die Ausführungsform einerseits das körperliche Gebilde mit den erfindungsgemäßen Merkmalen und andererseits auch einen digitalen Zwilling, wie er beispielsweise zum Zwecke der Simulation der Anordnung bzw. des Betriebes der Anordnung mittels mindestens eines Computers eingesetzt wird. Daneben bezieht sich die Ausführungsform auch auf ein nicht beanspruchtes entsprechendes Computerprogrammprodukt. Das Computerprogrammprodukt umfasst Befehle, die bei der Ausführung des Computerprogrammprodukts durch einen Computer diesen veranlassen, die einzelnen Bestandteile der erfindungsgemäßen Anordnung in einer Simulationsumgebung als computersimulierte Teile virtuell abzubilden und deren physikalischen Wechselwirkungen in der Simulationsumgebung vollständig oder teilweise zu analysieren, um das computerimplementierte Verfahren auszuführen.

Ein Aspekt betrifft ferner ein nicht beanspruchtes Datenagglomerat mit in einer gemeinsamen Datei zusammengefassten oder über verschiedene Dateien verteilten Datenpaketen zur Abbildung der dreidimensionalen Formgestaltung und/oder der Wechselwirkungen sämtlicher in der Anordnung, die wie vorstehend beschrieben aus- und weitergebildet sein kann, vorgesehenen Bestandteile, wobei die Datenpakete dazu hergerichtet sind bei einer Verarbeitung durch eine Datenverarbeitungseinrichtung eine additive Herstellung der Bestandteile der Anordnung, die wie vorstehend beschrieben aus- und weitergebildet sein kann, insbesondere durch 3D-Druck, und/oder eine Simulation der Funktionsweise der Anordnung, die wie vorstehend beschrieben aus- und weitergebildet sein kann, durchzuführen. Das Datenagglomerat kann in der Art eines sogenannten "digital twin" eine virtuelle Verkörperung der erfindungsgemäßen Anordnung, darstellen, die eine virtuelle Untersuchung in Form einer Simulation oder eine reale Vergegenständlichung mit Hilfe eines additiven Fertigungsverfahrens ermöglicht. Hierbei kann insbesondere jeweils ein Datenpaket einen separat ausgeführten Bestandteil der erfindungsgemäßen Anordnung abbilden, so dass die einzelnen Bestandteile in ihrer Relativlage und/oder Relativbeweglichkeit leicht tatsächlich und/oder virtuell zusammengesetzt werden können, um die erfindungswesentlichen Wechselwirkungen zu realisieren. Dies ermöglicht eine kostengünstige Herstellung von Prototypen und/oder computerbasierten Simulationen, um die Funktionsweise der erfindungsgemäßen Anordnung zu studieren, Probleme im konkreten Anwendungsfall zu identifizieren und Verbesserungen zu finden. Vorzugsweise können einzelne und/oder sämtliche Datenpakete des Datenagglomerats in die Simulationsumgebung des computerimplementierten Verfahrens und/oder das Computerprogrammprodukt, beispielsweise als Teil einer Datenbank oder Library, geladen und zur virtuellen Abbildung als computersimulierte Teile und/oder deren physikalischen Wechselwirkungen hochgeladen werden.

Weitere Merkmale, Eigenschaften und Vorteile der vorliegenden Erfindung ergeben sich aus der nachfolgenden Beschreibung unter Bezugnahme auf die Figuren. Darin zeigen schematisch:
- Figur 1: eine vereinfachte, zweidimensionale Längsschnittdarstellung einer erfindungsgemäßen Anordnung,
- Figur 2: eine schematische Darstellung einer auf einem Computer ablaufenden Simulation einer Anordnung nach der Erfindung, Computerprogrammprodukt.

In den Ausführungsbeispielen und Figuren können gleiche oder gleich wirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein.

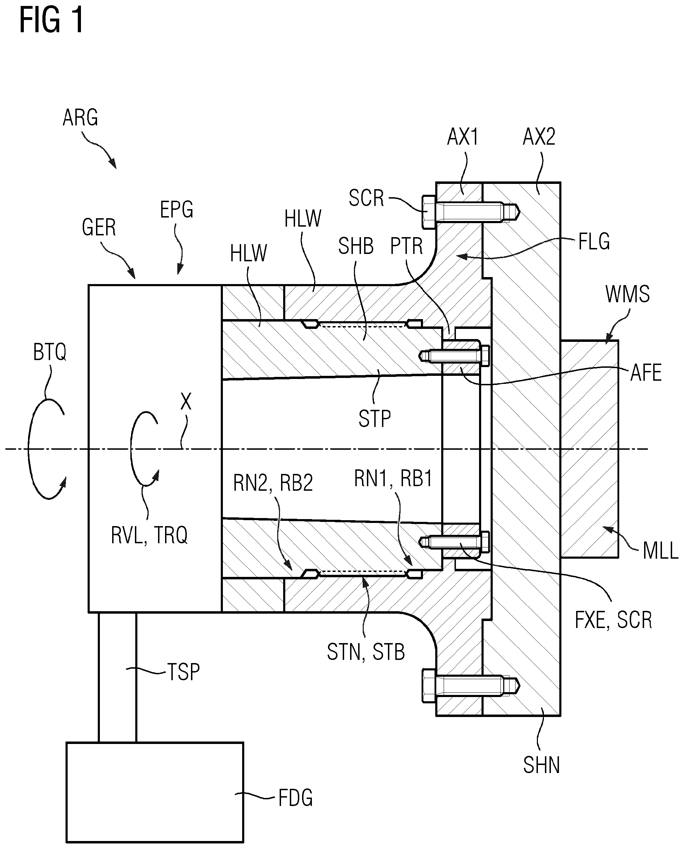

Figur 1 zeigt eine vereinfachte, zweidimensionale Längsschnittdarstellung einer erfindungsgemäßen Anordnung ARG mit einer Abtriebswelle SHB eines Getriebes GER, die sich entlang einer Achse X erstreckt. Das Getriebe GER ist als Planetengetriebe EPG ausgebildet. Die Abtriebswelle SHB ist mit einer Antriebswelle SHN drehsteif und biegesteif verbundenen. Die Antriebswelle SHN steht mit einer Arbeitsmaschine, insbesondere einer Mühle MLL in drehmomentübertragender Verbindung. Das Getriebe GER ist an der Arbeitsmaschine WMS mittels der Verbindung der Abtriebswelle SHB mit der Antriebswelle SHN und mittels einer Drehmomentstütze TSP zu mindestens 90% - bevorzugt vollständig - der im Betrieb entstehenden Kräfte abgestützt. Kräfte BTQ (insbesondere Biegelasten, Querkräfte) aus dem nicht dargestellten Antrieb des Getriebes GER, werden in die Antriebswelle SHN und die Drehmomentstütze TSP (hier insbesondere Kräfte aus einem Differenzdrehmoment infolge des Getriebes GER) eingeleitet. Das Drehmoment am Getriebe GER bzw. Getriebegehäuse wird mittels der Drehmomentstütze TSP abgeleitet, z.B. indirekt oder direkt in ein Fundament FDG eingeleitet.

An einem axialen Ende der Antriebswelle SHN ist die Abtriebswelle SHB angeschlossen. Mittels einer Abtriebswellenkurzverzahnung STB wird ein Drehmoment TRQ mit einer Drehzahl RVL übertragen von der Abtriebswelle SHB auf eine Antriebswellenkurzverzahnung STN der Antriebswelle SHN.

Das axiale Ende der Antriebswelle SHN, das an der Abtriebswelle SHB angeschlossen ist, ist als Hohlwelle HLW ausgeführt. Hierbei weist das axiale Ende der Abtriebswelle SHB einen Stumpf STP auf, der zumindest teilweise in der Hohlwelle HLW der Antriebswelle SHN angeordnet ist.

Die Antriebswelle SHN ist modular aufgebaut, derart, dass das axiale Ende der Antriebswelle SHN als ein erster Axialabschnitt AX1 als ein Flansch FLG ausgebildet ist, der axial an einem zweiten Axialabschnitt AX2 der Antriebswelle SHN angebracht ist, wobei der Flansch FLG den endseitigen axialen Wellenabschnitt bildet, der als Hohlwelle HLW ausgebildet ist. Der Flansch FLG ist an dem zweiten Axialabschnitt AX2 mittels Schrauben SCR befestigt und als Gussbauteil, insbesondere aus Metall, ausgebildet.

Die Antriebswelle SHN weist in dem Bereich der Ausbildung als Hohlwelle HLW eine radial nach innen ragende Ausformung PTR auf, wobei an dem als Stumpf STP ausgebildeten axialen Ende der Abtriebswelle SHB ein Halteelement AFE mittels axial wirkenden Befestigungsmitteln FXE Schrauben SCR befestigt ist, derart, dass die Ausformung PTR in dem Bereich zwischen dem Halteelement AFE und einer axialen Anlagefläche der sonstigen Abtriebswelle SHB eingeklemmt ist.

Das Halteelement AFE ist ringförmig und in Umfangsrichtung einteilig ausgebildet.

An dem axialen Ende der Antriebswelle SHN ist eine erste radiale Antriebswellenzentrierung RN1 vorgesehen und an dem axialen Ende der Abtriebswelle SHB, an dem die Antriebswelle SHN angeschlossen wird, ist eine radiale Abtriebswellenzentrierung RB1 vorgesehen ist, wobei die beiden Zentrierungen radial zentrierend miteinander in Kontakt stehen.

Die Verbindung der Abtriebswelle SHB mit der Antriebswelle SHN ist biegesteif ausgebildet, dadurch, dass an dem axialen Ende der Antriebswelle SHN, eine zu der ersten radialen Antriebswellenzentrierung RN1 axial beabstandete zweite radiale Antriebswellenzentrierung RN2 vorgesehen ist, wobei an dem axialen Ende der Abtriebswelle SHB, eine zu der ersten radialen Abtriebswellenzentrierung RB1 axial beabstandete zweite radiale Abtriebswellenzentrierung RB2 vorgesehen ist, wobei die Abtriebswellenzentrierungen RB1, RB2 und Antriebswellenzentrierungen RN1, RN2 paarweise zueinander zu zwei axial beabstandeten Zentrierungspaaren zugeordnet sind und jeweils radial zentrierend miteinander in Kontakt stehen.

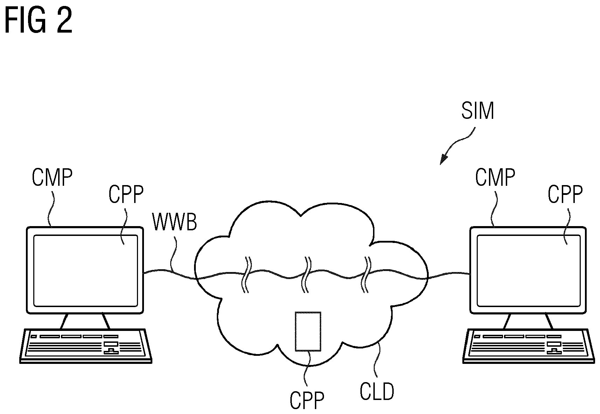

Figur 2 zeigt eine schematische Darstellung einer auf einem Computer CMP - hier auf mehreren Computern CMP eines Netzwerks WWB umfassend eine Cloud CLD - ablaufenden Simulation SIM einer Anordnung ARG nach der Erfindung. Die auf den Computern CMP installierte Software ist ein Computerprogrammprodukt CPP, das bei Ausführung auf mindestens einem Computer CMP dem Benutzer mittels Schnittstellen Bildschirm, Tastatur eine Einflussnahme bzw. Konfiguration und einen Erkenntnisgewinn auf Basis der ausgeführten Simulation SIM ermöglicht, so dass insbesondere technische Gestaltungsentscheidungen mittels der Simulation unterstützt und verifiziert werden können.

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

## Patentansprüche

1. Anordnung (ARG) umfassend ein antriebsseitiges Getriebe (GER) mit einer Abtriebswelle (SHB) des Getriebes (GER), die sich entlang einer Achse (X) erstreckt, und umfassend eine Arbeitsmaschine (WMS) mit einer mit der Abtriebswelle (SHB) drehsteif verbundenen Antriebswelle (SHN),
wobei das Getriebe (GER) an der Arbeitsmaschine (WMS) mittels der Verbindung der Abtriebswelle (SHB) mit der Antriebswelle (SHN) und mittels einer Drehmomentstütze (TSP) zu mindestens 90% der im Betrieb entstehenden Kräfte abgestützt ist, wobei die Verbindung der Abtriebswelle (SHB) mit der Antriebswelle (SHN) zur Abstützung von Querkräften biegesteif ausgebildet ist,
wobei das axiale Ende der Antriebswelle (SHN) als Hohlwelle (HLW) ausgeführt ist,
wobei das axiale Ende der Abtriebswelle (SHB) einen Stumpf (STP) aufweist, der zumindest teilweise in der Hohlwelle (HLW) der Antriebswelle (SHN) angeordnet ist **dadurch gekennzeichnet, dass**
die Antriebswelle (SHN) in dem Bereich der Ausbildung als Hohlwelle (HLW) eine Ausformung (PTR) aufweist,
wobei an dem als Stumpf (STP) ausgebildeten axialen Ende der Abtriebswelle (SHB) ein Halteelement (AFE) mittels Befestigungsmitteln (FXE) befestigt ist, derart, dass die Ausformung (PTR) in dem Bereich zwischen dem Halteelement (AFE) und einer axialen Anlagefläche der sonstigen Abtriebswelle (SHB) eingeklemmt ist.

2. Anordnung (ARG) nach Anspruch 1, wobei die Antriebswelle (SHN) an der Abtriebswelle (SHB) über eine Radialabstützung zur Abtragung von Querkräften abgestützt ist.

3. Anordnung (ARG) nach Anspruch 1 oder 2, wobei die Antriebswelle (SHN) an der Abtriebswelle (SHB) über eine Axialabstützung zur Abtragung von Längskräften abgestützt ist.

4. Anordnung (ARG) nach einem der vorhergehenden Ansprüche, wobei die Antriebswelle (SHN) modular aufgebaut ist, derart, dass das axiale Ende der Antriebswelle (SHN) als ein erster Axialabschnitt (AX1) als ein Flansch (FLG) ausgebildet ist, der axial an einem zweiten Axialabschnitt (AX2) der Antriebswelle (SHN) angebracht ist, wobei der Flansch (FLG) den endseitigen axialen Wellenabschnitt bildet, der als Hohlwelle (HLW) ausgebildet ist.

5. Anordnung (ARG) nach Anspruch 4, wobei das Halteelement (AFE) rund oder ringförmig ausgebildet ist.

6. Anordnung (ARG) nach Anspruch 4 oder 5, wobei der Flansch (FLG) als Gussbauteil ausgebildet ist.

7. Anordnung (ARG) nach einem der vorhergehenden Ansprüche, wobei an einem axialen Ende der Abtriebswelle (SHB), an dem die Antriebswelle (SHN) angeschlossen wird, eine Abtriebswellenkurzverzahnung (STB) vorgesehen sind,
wobei an einem axialen Ende der Antriebswelle (SHN), an dem die Abtriebswelle (SHB) angeschlossen wird, eine Antriebswellenkurzverzahnung (STN) vorgesehen sind.

8. Anordnung (ARG) nach einem der vorhergehenden Ansprüche, wobei das Getriebe (GER) an der Arbeitsmaschine (WMS) mittels der Verbindung der Abtriebswelle (SHB) mit der Antriebswelle (SHN) und mittels der Drehmomentstütze (TSP) vollständig gegen die im Betrieb entstehenden Kräfte abgestützt ist.

9. Anordnung (ARG) nach mindestens einem der vorhergehenden Ansprüche, wobei an einem axialen Ende der Antriebswelle (SHN), mindestens eine erste radiale Antriebswellenzentrierung (RN1) vorgesehen ist,
wobei an einem axialen Ende der Abtriebswelle (SHB), an dem die Antriebswelle (SHN) angeschlossen wird, mindestens eine radiale Abtriebswellenzentrierung (RB1) vorgesehen ist, wobei die beiden Zentrierungen radial zentrierend miteinander in Kontakt stehen.

10. Anordnung (ARG) nach Anspruch 9, wobei an dem axialen Ende der Antriebswelle (SHN), eine zu der ersten radialen Antriebswellenzentrierung (RN1) axial beabstandete zweite radiale Antriebswellenzentrierung (RN2) vorgesehen ist,
wobei an dem axialen Ende der Abtriebswelle (SHB), eine zu der ersten radialen Abtriebswellenzentrierung (RB1) axial beabstandete zweite radiale Abtriebswellenzentrierung (RB2) vorgesehen ist, wobei die Abtriebswellenzentrierungen (RB1, RB2) und Antriebswellenzentrierungen (RN1, RN2) paarweise zueinander zu zwei axial beabstandeten Zentrierungspaaren zugeordnet sind und jeweils radial zentrierend miteinander in Kontakt stehen.

11. Anordnung (ARG) nach mindestens einem der vorhergehenden Ansprüche, wobei die Abtriebswelle (SHB) und/oder die Antriebswelle (SHN) und/oder die Drehmomentstütze (TSP) aus Metall bestehen.

12. Anordnung (ARG) nach Anspruch 4, wobei der Flansch (FLG) aus Metall besteht.

## Claims

1. Arrangement (ARG) comprising a drive-side transmission (GER) with an output shaft (SHB) of the transmission (GER), which extends along an axis (X), and comprising a work machine (WMS) with a drive shaft (SHN) connected in a rotationally fixed manner to the output shaft (SHB),
wherein the transmission (GER) on the work machine (WMS), by means of the connection between the output shaft (SHB) and the drive shaft (SHN) and by means of a torque arm (TSP), is supported to the extent of at least 90% of the forces arising during operation,
wherein the connection between the output shaft (SHB) and the drive shaft (SHN) is configured to be flexurally stiff to support transverse forces, wherein the axial end of the drive shaft (SHN) is embodied as a hollow shaft (HLW),
wherein the axial end of the output shaft (SHB) has a stub (STP) which is at least partially disposed in the hollow shaft (HLW) of the drive shaft (SHN), **characterized in that**
the drive shaft (SHN) in the region of the configuration as a hollow shaft (HLW) has a moulding (PTR),
wherein a holding element (AFE) by means of fastening means (FXE) is fastened to the axial end of the output shaft (SHB) configured as a stub (STP) in such a manner that the moulding (PTR) is jammed in the region between the holding element (AFE) and an axial contact surface of the remaining part of the output shaft (SHB).

2. Arrangement (ARG) according to Claim 1, wherein the drive shaft (SHN) is supported on the output shaft (SHB) via a radial support for dissipating transverse forces.

3. Arrangement (ARG) according to Claim 1 or 2, wherein the drive shaft (SHN) is supported on the output shaft (SHB) via an axial support for dissipating longitudinal forces.

4. Arrangement (ARG) according to one of the preceding claims, wherein the drive shaft (SHN) is constructed in a modular manner such that the axial end of the drive shaft (SHN) as a first axial portion (AX1) is configured as a flange (FLG) which is attached axially to a second axial section (AX2) of the drive shaft (SHN), wherein the flange (FLG) forms the end-side axial shaft section which is configured as a hollow shaft (HLW).

5. Arrangement (ARG) according to Claim 4, wherein the holding element (AFE) is of a round or ring-shaped configuration.

6. Arrangement (ARG) according to Claim 4 or 5, wherein the flange (FLG) is configured as a casting.

7. Arrangement (ARG) according to one of the preceding claims, wherein an output shaft short spline (STB) is provided on an axial end of the output shaft (SHB) to which the drive shaft (SHN) is connected, wherein a drive shaft short spline (STN) is provided on an axial end of the drive shaft (SHN) to which the output shaft (SHB) is connected.

8. Arrangement (ARG) according to one of the preceding claims, wherein the transmission (GER) on the work machine (WMS) by means of the connection between the output shaft (SHB) and the drive shaft (SHN) and by means of the torque arm (TSP) is supported completely against the forces arising during operation.

9. Arrangement (ARG) according to at least one of the preceding claims, wherein at least one first radial drive shaft centring feature (RN1) is provided on an axial end of the drive shaft (SHN),
wherein at least one radial output shaft centring feature (RB1) is provided on an axial end of the output shaft (SHB) to which the drive shaft (SHN) is connected,
wherein the two centring features are in mutual contact in a radially centring manner.

10. Arrangement (ARG) according to Claim 9, wherein a second radial drive shaft centring feature (RN2) which is axially spaced apart from the first radial drive shaft centring feature (RN1) is provided on the axial end of the drive shaft (SHN),
wherein a second radial output shaft centring feature (RB2) which is axially spaced apart from the first radial output shaft centring feature (RB1) is provided on the axial end of the output shaft (SHB), wherein the output shaft centring features (RB1, RB2) and drive shaft centring features (RN1, RN2) are assigned in pairs to one another to form two axially spaced-apart centring feature pairs and are in each case in mutual contact in a radially centring manner.

11. Arrangement (ARG) according to at least one of the preceding claims, wherein the output shaft (SHB) and/or the drive shaft (SHN) and/or the torque arm (TSP) are composed of metal.

12. Arrangement (ARG) according to Claim 4, wherein the flange (FLG) is composed of metal.

## Revendications

1. Agencement (ARG) comprenant une transmission (GER) côté entraînement avec un arbre de sortie (SHB) de la transmission (GER) qui s'étend le long d'un axe (X), et comprenant une machine de travail (WMS) avec un arbre d'entraînement (SHN) relié à l'arbre de sortie (SHB) de manière rigide en rotation, la transmission (GER) étant supportée sur la machine de travail (WMS) au moyen de la liaison de l'arbre de sortie (SHB) avec l'arbre d'entraînement (SHN) et au moyen d'un support de couple (TSP) pour au moins 90% des forces générées en fonctionnement, la liaison de l'arbre de sortie (SHB) avec l'arbre d'entraînement (SHN) étant conçue de manière rigide en flexion pour supporter les forces transversales,
l'extrémité axiale de l'arbre d'entraînement (SHN) étant réalisée sous forme d'arbre creux (HLW),
l'extrémité axiale de l'arbre de sortie (SHB) présentant un moignon (STP) qui est disposé au moins partiellement dans l'arbre creux (HLW) de l'arbre d'entraînement (SHN), **caractérisé en ce que**
l'arbre d'entraînement (SHN) présente une conformation (PTR) dans la zone de la réalisation sous forme d'arbre creux (HLW), un élément de retenue (AFE) étant fixé à l'extrémité axiale de l'arbre de sortie (SHB) réalisée sous forme de moignon (STP) à l'aide de moyens de fixation (FXE), de telle sorte que la conformation (PTR) soit serrée dans la zone entre l'élément de retenue (AFE) et une surface d'appui axiale de l'autre arbre de sortie (SHB) .

2. Agencement (ARG) selon la revendication 1, dans lequel l'arbre d'entrée (SHN) est supporté sur l'arbre de sortie (SHB) par l'intermédiaire d'un support radial pour transférer des efforts transversaux.

3. Agencement (ARG) selon la revendication 1 ou la revendication 2, dans lequel l'arbre d'entraînement (SHN) est supporté sur l'arbre de sortie (SHB) par un support axial pour transférer des efforts longitudinaux.

4. Agencement (ARG) selon l'une des revendications précédentes, dans lequel l'arbre d'entraînement (SHN) est de construction modulaire, de telle sorte que l'extrémité axiale de l'arbre d'entraînement (SHN) soit réalisée sous la forme d'une première section axiale (AX1) sous la forme d'une bride (FLG) qui est montée axialement sur une deuxième section axiale (AX2) de l'arbre d'entraînement (SHN), la bride (FLG) formant la section d'arbre axiale côté extrémité, qui est réalisée sous la forme d'un arbre creux (HLW).

5. Agencement (ARG) selon la revendication 4, dans lequel l'élément de retenue (AFE) est de forme ronde ou annulaire.

6. Agencement (ARG) selon la revendication 4 ou la revendication 5, dans lequel la bride (FLG) est réalisée sous forme de composant moulé.

7. Agencement (ARG) selon l'une des revendications précédentes, dans lequel une denture courte (STB) d'arbre de sortie est prévue à une extrémité axiale de l'arbre de sortie (SHB) à laquelle est raccordé l'arbre d'entrée (SHN),
une denture courte (STN) d'arbre d'entrée étant prévue à une extrémité axiale de l'arbre d'entrée (SHN), à laquelle l'arbre de sortie (SHB) est relié.

8. Agencement (ARG) selon l'une des revendications précédentes, dans lequel la transmission (GER) est entièrement soutenue sur la machine de travail (WMS) au moyen de la liaison de l'arbre de sortie (SHB) à l'arbre d'entraînement (SHN) et au moyen du support de couple (TSP) contre les forces générées en fonctionnement.

9. Agencement (ARG) selon au moins une des revendications précédentes, dans lequel au moins un premier centrage radial (RN1) de l'arbre d'entraînement est prévu à une extrémité axiale de l'arbre d'entraînement (SHN),
au moins un centrage radial (RB1) d'arbre de sortie étant prévu à une extrémité axiale de l'arbre de sortie (SHB), à laquelle l'arbre d'entraînement (SHN) est relié,
les deux centrages étant en contact radial de centrage l'un avec l'autre.

10. Agencement (ARG) selon la revendication 9, dans lequel il est prévu, à l'extrémité axiale de l'arbre d'entraînement (SHN), un deuxième centrage radial (RN2) de l'arbre d'entraînement, espacé axialement du premier centrage radial (RN1) de l'arbre d'entraînement,
à l'extrémité axiale de l'arbre de sortie (SHB), il est prévu un deuxième centrage radial (RB2) d'arbre de sortie espacé axialement du premier centrage radial (RB1) d'arbre de sortie, les centrages (RB1, RB2) d'arbre de sortie et les centrages (RN1, RN2) d'arbre d'entrée étant associés par paires l'un à l'autre pour former deux paires de centrages espacées axialement et étant respectivement en contact de centrage radial.

11. Agencement (ARG) selon au moins l'une des revendications précédentes, dans lequel l'arbre de sortie (SHB) et/ou l'arbre d'entrée (SHN) et/ou le support de couple (TSP) sont en métal.

12. Agencement (ARG) selon la revendication 4, dans lequel la bride (FLG) est en métal.
